# EUROPÄISCHE PATENTSCHRIFT

(11) **EP 2 351 226 B1**
(45) Veröffentlichungstag und Bekanntmachung des Hinweises auf die Patenterteilung: **07.05.2014**
(21) Anmeldenummer: 09752147.0
(22) Anmeldetag: 30.10.2009
(51) Int. Cl.: H03M 1/10

(54) **FELDGERÄT FÜR DIE PROZESSAUTOMATISIERUNG**
FIELD DEVICE FOR PROCESS AUTOMATION
APPAREIL DE CHAMP POUR L'AUTOMATISATION DES PROCESSUS

(30) Priorität: 30.10.2008 DE 102008054053
(43) Veröffentlichungstag der Anmeldung: 03.08.2011
(73) Patentinhaber: Siemens Aktiengesellschaft, 80333 München (DE)
(72) Erfinder: IDIART, Marco , Enrique, 76185 Karlsruhe (DE)
(86) Internationale Anmeldenummer: PCT/EP2009/064335
(87) Internationale Veröffentlichungsnummer: WO 2010/049513

(56) Entgegenhaltungen:
- JP-A- 1 138 478

## Beschreibung

Die Erfindung betrifft ein Feldgerät nach dem Oberbegriff des Anspruchs 1.

Ein derartiges Gerät ist aus der JP 01 138478 A bekannt.

In Feldgeräten werden oft durch digitale Signalverarbeitung ein digitales Mess-, Steuer- oder Regelsignal erzeugt, das anschließend in ein entsprechendes niederfrequentes analoges Spannungs- oder Stromsignal umsetzt wird.

Ein Beispiel hierfür ist eine Regel- oder Stelleinrichtung, in der eine Signalverarbeitungseinrichtung (z. B. Digitalregler) ein digitales Steuer- oder Regelsignal erzeugt, das anschließend mittels einer Ausgangsstufe in ein analoges Spannungs- oder Stromsignal zur Ansteuerung eines Stellgliedes (z. B. Ventil) umsetzt wird.

Ein weiteres Beispiel ist ein Messumformer, der dazu dient, eine physikalische Größe (z. B. Temperatur) zu erfassen und in ein Ausgangssignal umzusetzen, das beispielsweise an eine Steuer- oder Regeleinrichtung übertragen wird. Ein die physikalische Größe erfassender Sensor liefert ein in der Regel analoges elektrisches Rohsignal. Das Ausgangssignal des Messumformers kann digital oder analog sein, wobei im hier betrachteten letzteren Fall das Ausgangssignal ein Stromsignal, üblicherweise im Bereich 4 bis 20 mA ist. Dem mit bis etwa 100 Hz niederfrequenten analogen Stromsignal kann entsprechend der HART-Spezifikation ein höherfrequentes digitales Signal im kHz-Bereich überlagert sein. Das von dem Sensor gelieferte Rohsignal wird mittels einer Signalverarbeitungseinrichtung zu einem digitalen Messsignal verarbeitet, wobei die Signalverarbeitung in der Regel analoge Signalverarbeitungsschritte, wie Analogfilterung und Vorverstärkung, sowie digitale Signalverarbeitungsschritte, wie Nullpunktfestlegung, Skalierung (Festlegung des Messbereichs) und Signalaufbereitung anhand einer spezifischen Übertragungsfunktion umfasst. Anschließend wird das digitale Messsignal mittels einer Ausgangsstufe in das gewünschte analoge Stromsignal umgesetzt.

Zur Erzeugung des analogen Spannungs- oder Stromsignals muss das digitale Mess-, Steuer- oder Regelsignal zuvor in ein analoges Signal umgewandelt werden. Dies kann beispielsweise durch Pulsweitenmodulation (PWM) und nachgeordnete Analogfilterung erfolgen, so wie dies aus der DE 10 2005 018 398 A1 bekannt ist.

Um Fehler bei einer Signalverarbeitung zu erkennen, ist es bekannt, die Signalverarbeitung redundant oder diversitär auszuführen und die Ergebnisse der Signalverarbeitung auf Übereinstimmung zu prüfen. Es ist auch bekannt, dass Ergebnis eines Signalverarbeitungsalgorithmus zurückzurechnen und mit dem Eingangssignal zu vergleichen.

Aus der WO 03/060851 A1 ist ein Messumformer bekannt, bei dem in einer Überwachungseinrichtung aus dem von dem Sensor gelieferten Rohsignal nach Durchlaufen einer Signalvorverarbeitung ein Hilfssignal gebildet wird, das mit dem Ausgangssignal, z. B. 4 bis 20 mA-Stromsignal, des Messumformers verglichen wird, um im Falle einer ein vorgegebenes Maß überschreitenden Abweichung eine Fehlermeldung und zur sicherheitsgerichteten Einstellung des Ausgangssignals auszulösen. Zur Bildung des Hilfssignals wird das Rohsignal in einem zusätzlich zu dem Mikroprozessor der Signalverarbeitung vorgesehenen weiteren Mikroprozessor mit der Übertragungsfunktion der Signalverarbeitung verarbeitet.

Bei dem aus der eingangs genannten JP 01 138478 A bekannten Gerät wird das von der Ausgangsstufe aus dem digitalen Signal der Signalverarbeitungseinrichtung erzeugte analoge Spannungs- oder Stromsignal wieder in ein digitales Signal umgesetzt, das in einem Vergleicher mit dem digitalen Signal der Signalverarbeitungseinrichtung verglichen wird, um im Falle einer Abweichung eine Fehlermeldung zu erzeugen.

Die Umsetzung des von der Signalverarbeitungseinrichtung erzeugten digitalen Messsignals in das analoge Ausgangssignal ist von dem dynamischen Verhalten der Ausgangsstufe (z. B. Signalverzögerung durch Zeitkonstante der Ausgangsstufe) beeinflusst, was den Signalvergleich erschwert und zu unerwünschten Fehlermeldungen führen kann.

Gemäß der Erfindung werden der vorstehend genannte Nachteil durch das in Anspruch 1 definierte Feldgerät vermieden, von dem vorteilhafte Weiterbildungen in den Unteransprüchen angegeben sind.

Gegenstand der Erfindung ist somit ein Feldgerät für die Prozessautomatisierung mit
- einer Signalverarbeitungseinrichtung, die ein digitales Mess-, Steuer- oder Regelsignal erzeugt,
- einer Ausgangsstufe, die das digitale Mess-, Steuer- oder Regelsignal in ein entsprechendes niederfrequentes analoges Spannungs- oder Stromsignal umsetzt, und
- einer Überwachungseinrichtung umfassend
   - eine Messeinrichtung, die das analoge Spannungs- oder Stromsignal erfasst und in ein digitales Spannungs- oder Strommesssignal umsetzt, und
   - einen der Signalverarbeitungseinrichtung und der Messeinrichtung nachgeordneten Vergleicher,
dadurch gekennzeichnet,
- dass zwischen der Signalverarbeitungseinrichtung (3) und dem Vergleicher (19)ein erstes digitales Tiefpassfilter zur Filterung des digitalen Mess-, Steuer- oder Regelsignals liegt, wobei die Eckfrequenz des Tiefpassfilters kleiner als die Grenzfrequenz der Ausgangsstufe bemessen ist,
- dass zwischen der Messeinrichtung und dem Vergleicher ein zweites digitales Tiefpassfilter mit der gleichen Eckfrequenz wie die des ersten digitalen Tiefpassfilters zur Filterung des digitalen Spannungs- oder Strommesssignals liegt und
- dass dem Vergleicher eine Auswerteeinrichtung nachgeordnet ist, die eine Fehlermeldung erzeugt, wenn die Abweichung zwischen beiden verglichenen Signalen ein vorgegebenes Maß überschreitet.

Bei dem erfindungsgemäßen Feldgerät wird die Umsetzung des digitalen Mess-, Steuer- oder Regelsignals in das entsprechende analoge Spannungs- oder Stromsignal überwacht. Dadurch, dass das digitale Mess-, Steuer- oder Regelsignal und das in ein digitales Spannungs- oder Strommesssignal umgesetzte erfasste Spannungs- oder Stromsignal vor dem Vergleich jeweils tiefpassgefiltert werden, bleibt das dynamische Verhalten der Ausgangsstufe oberhalb der Eckfrequenz der Tiefpassfilter bei dem Vergleich unberücksichtigt und kann nicht zu unerwünschten Fehlermeldungen führen.

Dieser Vorteil zeigt sich insbesondere bei einer Ausgangsstufe, die einen Pulsweitenmodulator, gefolgt von einem analogen Tiefpassfilter und ggf. einem diesem nachgeordneten Spannungs-/Stromumsetzer umfasst.

Die Eckfrequenz der beiden digitalen Tiefpassfilter ist dabei vorzugsweise um ein Mehrfaches, z. B. etwa 10-faches, kleiner als die Grenzfrequenz der Ausgangsstufe bemessen. Hierbei kann jedoch das Problem auftreten, dass innerhalb des Nutzfrequenzbereichs des Spannungs- oder Stromsignals oberhalb der Eckfrequenz der Tiefpassfilter auftretende Störungen unerkannt bleiben. Um dies zu verhindern, ist die Grenzfrequenz der Ausgangsstufe um ein Mehrfaches größer als die Grenzfrequenz des niederfrequenten Spannungs- oder Stromsignals bemessen, so dass die Eckfrequenz der Tiefpassfilter in der Nähe der oberen Grenzfrequenz des Spannungs- oder Stromsignals zu liegen kommt.

Die dem Vergleicher zugeführten tiefpassgefilterten Signale können einen Zeitversatz aufweisen, der durch die unterschiedlichen Signalwege des digitalen Mess-, Steuer- oder Regelsignals vom Ausgang der Signalverarbeitungseinrichtung bis zu den Eingängen des Vergleichers bedingt ist. Um aus diesem Zeitversatz resultierende unerwünschte Fehlermeldungen zu vermeiden, ist vorzugsweise dem ersten digitalen Tiefpassfilter eine das diesem zugeführte digitale Mess-, Steuer- oder Regelsignal verzögernde Verzögerungsstufe vorgeordnet, deren Verzögerung entsprechend der Signalverzögerung vom Ausgang der Signalverarbeitungseinrichtung bis zum Ausgang der Messeinrichtung bemessen ist.

Um unerwünschte Fehlermeldungen aufgrund kurzzeitiger Störungen, wie z. B. Störimpulse, zu verhindern, ist vorzugsweise zwischen dem Vergleicher und der Auswerteeinrichtung ein dritter Tiefpassfilter eingefügt.

Alternativ kann der Auswerteeinrichtung eine Zähleinrichtung zugeordnet sein, wobei die Auswerteeinrichtung die Fehlermeldung erzeugt, wenn die Häufigkeit der das vorgegebene Maß überschreitenden Abweichungen zwischen beiden verglichenen Signalen eine vorgegebene Anzahl überschreitet.

Zur weiteren Erläuterung der Erfindung wird im Folgenden auf die Figuren der Zeichnung Bezug genommen; im Einzelnen zeigen:
- Figur 1: als vereinfachtes Blockschaltbild ein Ausführungsbeispiel des erfindungsgemäßen Feldgeräts in Form eines Messumformers,
- Figur 2: ein Beispiel für den zeitlichen Verlauf des digitalen Messsignals, analogen Stromsignals und tiefpassgefilterten Messsignals und
- Figur 3: als vereinfachtes Blockschaltbild ein weiteres Ausführungsbeispiel des erfindungsgemäßen Feldgeräts in Form einer Regeleinrichtung.

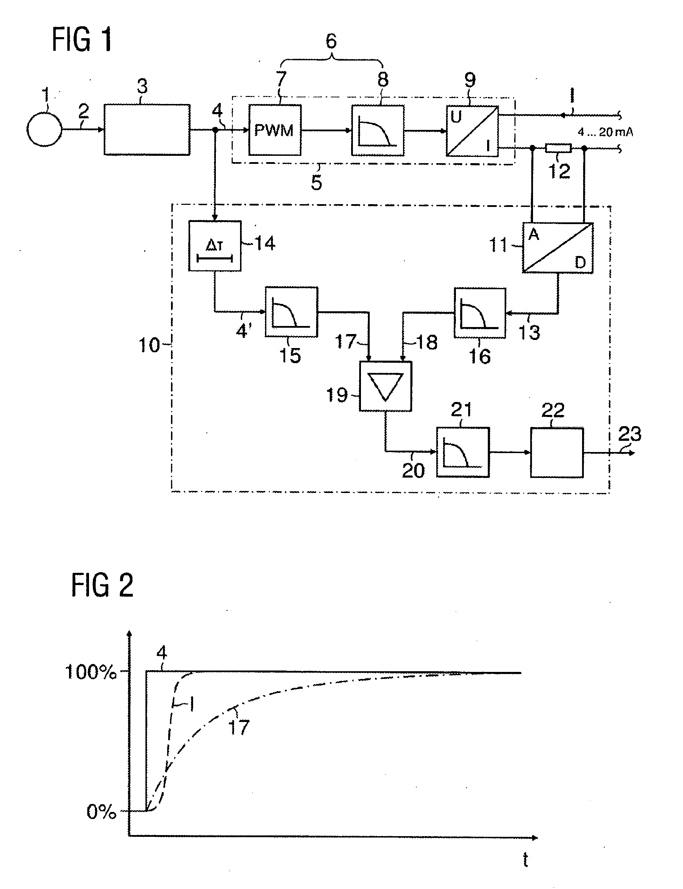

Figur 1 zeigt einen Messumformer mit einem Sensor 1, der eine physikalische Größe, zum Beispiel Temperatur, erfasst und in ein analoges Rohsignal 2 umsetzt. Das Rohsignal 2 wird in einer Signalverarbeitungseinrichtung 3 zugeführt, in der eine analoge Signalvorverarbeitung, eine Analog-/Digital-Umsetzung und schließlich eine digitale Verarbeitung des Rohsignals 2 zu einem digitalen Messsignal 4 erfolgt. Das Messsignal 4 wird in einer Ausgangsstufe 5 in ein analoges 4 bis 20 mA-Stromsignal I umgesetzt. Die Ausgangsstufe 5 enthält dazu einen Digital-/Analog-Umsetzer 6 bestehend aus einem Pulsweitenmodulator 7 mit einem nachgeordneten analogen Tiefpassfilter 8, und einen Spannungs-/Stromumsetzer 9.

Zur Überwachung der Umsetzung des digitalen Messsignals 4 in das entsprechende analoge Stromsignal I ist eine Überwachungseinrichtung 10 vorgesehen, der beide Signale 4 und I zugeführt werden. Das Ausgangssignal 6 kann, soweit die entsprechenden Mittel vorhanden sind, direkt von dem Spannungs-/Stromumsetzer 9 bezogen werden oder, wie hier gezeigt, mittels einer Messeinrichtung 11 als Spannungsabfall über einem Strommesswiderstand 12 erfasst und in ein digitales Strommesssignal 13 umgesetzt werden. Das digitale Messsignal 4 wird einer Verzögerungsstufe 14 zugeführt, deren Verzögerung so bemessen ist, dass sie in etwa der Verzögerung des Messsignals 4 auf dem Weg vom Eingang der Ausgangsstufe 5 bis zum Ausgang der Messeinrichtung 11 entspricht. Das verzögerte Messsignal 4' und das digitale Strommesssignal 13 werden jeweils einem ersten bzw. zweiten Tiefpassfilter 15, 16 erster Ordnung zugeführt, dessen Eckfrequenz kleiner als die Grenzfrequenz der Ausgangsstufe 5 bemessen ist. Das tiefpassgefilterte digitale Messsignal 17 und das tiefpassgefilterte digitale Strommesssignal 18 werden in einem Vergleicher 19 miteinander verglichen. Der Vergleicher 19 erzeugt ein der Abweichung zwischen beiden Signalen 17 und 18 entsprechendes Vergleichssignal 20, das über ein weiteres Tiefpassfilter 21 einer Auswerteeinrichtung 22 zugeführt wird, die eine Fehlermeldung 23 erzeugt, wenn die Abweichung zwischen beiden verglichenen Signalen 17 und 18 ein vorgegebenes Maß überschreitet.

Figur 2 zeigt beispielhaft den zeitlichen Verlauf des digitalen Messsignals 4, des analogen Stromsignals I und des tiefpassgefilterten, hier unverzögerten, Messsignals 17. Das digitale Messsignal 4 weist als Soll-Signal einen hier z. B. sprungförmigen Verlauf von 0 auf 100% auf, während das analoge Stromsignals I als Ist-Signal im fehlerfreien Fall den Endwert von 100% in einem nicht sprungförmigen Verlauf nach einer gewissen Verzögerung erreicht. Diese Verzögerung ist durch das dynamische Verhalten der Ausgangsstufe 5 bedingt und frequenzabhängig. Obwohl also die Umsetzung des Messsignals 4 in das Stromsignal I fehlerfrei erfolgt, weichen beide Signalverläufe 4 und I voneinander ab und können nicht ohne weiteres miteinander verglichen werden. Wie anhand des Verlaufs des tiefpassgefilterten Messsignals 17 erkennbar ist, werden durch die Tiefpassfilterung die statischen Aspekte gegenüber den dynamischen Aspekten höher gewichtet: beide tiefpassgefilterten Signale 17 und 18 streben asymptotisch dem 100%-Wert zu. In Bezug auf das Stromsignal I bedeutet dies, dass das dynamische Verhalten der Ausgangsstufe 5 in dem tiefpassgefilterten digitalen Strommesssignal 18 nur noch eine geringe Rolle spielt. Das digitale Messsignal 4 wird deshalb tiefpassgefiltert, damit es die gleiche Signalverarbeitung wie das Stromsignal I erfährt und mit diesem verglichen werden kann. Die reine Verzögerung in der Ausgangsstufe 5 wird durch Verzögerungsstufe 14 nachgebildet.

Bei einer oberen Grenzfrequenz des Nutzfrequenzbereichs des Stromsignals I von beispielsweise 100 Hz, kann die Grenzfrequenz der Ausgangsstufe ≥ 100 Hz betragen. Die Eckfrequenz der Tiefpassfilter 15 und 16 wird um ein Mehrfaches kleiner als die Grenzfrequenz der Ausgangsstufe 5 gewählt und beträgt beispielsweise 10 Hz. Damit nicht innerhalb des Nutzfrequenzbereichs des Stromsignals I oberhalb der Eckfrequenz der Tiefpassfilter 15 und 16, also im Bereich 10 bis 100 Hz, auftretende Störungen unerkannt bleiben, ist die die Grenzfrequenz der Ausgangsstufe 5 um ein Mehrfaches größer als die Grenzfrequenz des Stromsignals I bemessen und beträgt z. B. 1000 Hz.

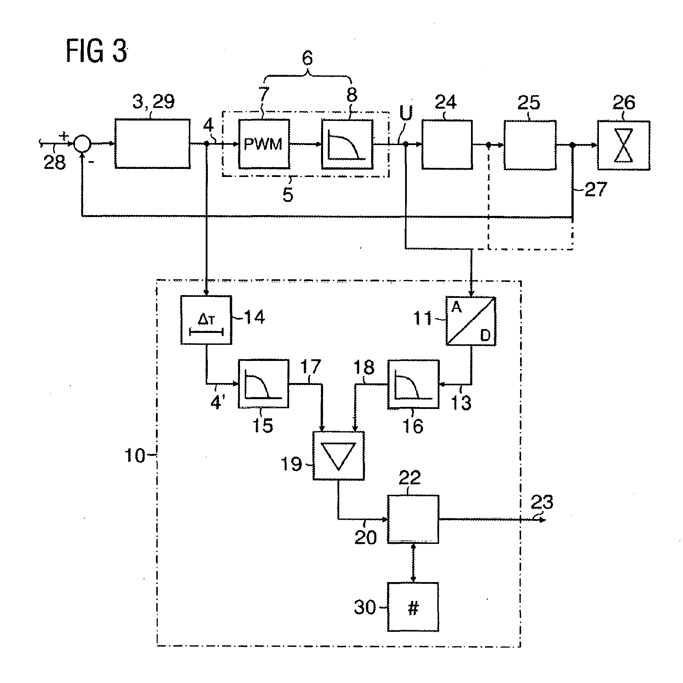

Figur 3 zeigt eine Regeleinrichtung, hier z. B. einen elektropneumatischen Stellungsregler (Positioner), der über ein elektrisch ansteuerbares Steuerventil 24 einen pneumatischen Antrieb 25 für ein Prozessventil 26 betätigt, um das Prozessventil 26 in eine vorgegebene Ventilstellung zu bewegen. Die Ist-Ventilstellung 27 wird erfasst und zusammen mit einer Soll-Ventilstellung 28 einer Signalverarbeitungseinrichtung 3 aufgegeben, die hier aus einem Digitalregler 29 besteht und ein digitales Regelsignal 4 erzeugt. Das Regelsignal 4 wird in einer Ausgangsstufe 5 in ein analoges Spannungssignal U zur Ansteuerung des Steuerventils 24 umgesetzt. Die Ausgangsstufe 5 enthält dazu einen Digital-/Analog-Umsetzer 6 bestehend aus einem Pulsweitenmodulator 7 mit einem nachgeordneten analogen Tiefpassfilter 8. Zur Überwachung der Umsetzung des digitalen Regelsignals 4 in das entsprechende analoge Spannungssignal U ist eine Überwachungseinrichtung 10 vorgesehen, der beide Signale 4 und U zugeführt werden und die weitgehend genauso aufgebaut ist und arbeitet, wie oben anhand von Figur 1 beschrieben. Lediglich ist alternativ zu dem weiteren Tiefpassfilter 21 der Auswerteeinrichtung 22 eine Zähleinrichtung 30 zugeordnet, wobei die Auswerteeinrichtung 22 die Fehlermeldung 23 erzeugt, wenn die Häufigkeit der das vorgegebene Maß überschreitenden Abweichungen zwischen beiden verglichenen Signalen 17 und 18 eine vorgegebene Anzahl überschreitet. Außerdem kann, wie gestrichelt angedeutet ist, anstelle des Spannungssignals U das Pneumatiksignal am Ausgang des Steuerventils 24 oder die Ist-Ventilstellung 27 der Überwachungseinrichtung 10 zugeführt werden.

## Patentansprüche

1. Feldgerät für die Prozessautomatisierung mit
- einer Signalverarbeitungseinrichtung (3), die ein digitales Mess-, Steuer- oder Regelsignal (4) erzeugt,
- einer Ausgangsstufe (5), die das digitale Mess-, Steuer- oder Regelsignal (4) in ein entsprechendes niederfrequentes analoges Spannungs- oder Stromsignal (U, I) umsetzt, und
- einer Überwachungseinrichtung (10) umfassend
- eine Messeinrichtung (11), die das analoge Spannungs- oder Stromsignal (U, I) erfasst und in ein digitales Spannungs- oder Strommesssignal (13) umsetzt, und
- einen der Signalverarbeitungseinrichtung (3) und der Messeinrichtung (11) nachgeordneten Vergleicher (19),
**dadurch gekennzeichnet,**
- **dass** zwischen der Signalverarbeitungseinrichtung (3) und dem Vergleicher (19) ein erstes digitales Tiefpassfilter (15) zur Filterung des digitalen Mess-, Steuer- oder Regelsignals (4) liegt, wobei die Eckfrequenz des Tiefpassfilters (15) kleiner als die Grenzfrequenz der Ausgangsstufe (5) bemessen ist,
- **dass** zwischen der Messeinrichtung (11) und dem Vergleicher (19) ein zweites digitales Tiefpassfilter (16) mit der gleichen Eckfrequenz wie die des ersten digitalen Tiefpassfilters (15) zur Filterung des digitalen Spannungs- oder Strommesssignals (13) liegt und
- **dass** dem Vergleicher (19) eine Auswerteeinrichtung (22) nachgeordnet ist, die eine Fehlermeldung (23) erzeugt, wenn die Abweichung zwischen beiden verglichenen Signalen (17, 18) ein vorgegebenes Maß überschreitet.

2. Feldgerät nach Anspruch 1, **dadurch gekennzeichnet, dass** die Ausgangsstufe (5) zur Erzeugung des analogen Spannungssignals (U) einen Pulsweitenmodulator (7), gefolgt von einem analogen Tiefpassfilter (8) umfasst.

3. Feldgerät nach Anspruch 1, **dadurch gekennzeichnet, dass** die Ausgangsstufe (5) zur Erzeugung des analogen Stromsignals (I) einen Pulsweitenmodulator (7), gefolgt von einem analogen Tiefpassfilter (8) und einem diesem nachgeordneten Spannungs-/Stromumsetzer (9) umfasst.

4. Feldgerät nach einem der vorangehenden Ansprüche, **dadurch gekennzeichnet, dass** die Eckfrequenz der beiden digitalen Tiefpassfilter (15, 16) um ein Mehrfaches kleiner als die Grenzfrequenz der Ausgangsstufe (5) bemessen ist.

5. Feldgerät nach Anspruch 3, **dadurch gekennzeichnet, dass** die Grenzfrequenz der Ausgangsstufe (5) um ein Mehrfaches größer als die Grenzfrequenz des niederfrequenten Spannungs- oder Stromsignals (U, I) bemessen ist.

6. Feldgerät nach einem der vorangehenden Ansprüche, **dadurch gekennzeichnet, dass** dem ersten digitalen Tiefpassfilter (15) eine das diesem zugeführte digitale Mess-, Steuer- oder Regelsignal (4) verzögernde Verzögerungsstufe (14) vorgeordnet ist, deren Verzögerung entsprechend der Signalverzögerung vom Ausgang der Signalverarbeitungseinrichtung (3) bis zum Ausgang der Messeinrichtung (11) bemessen ist.

7. Feldgerät nach einem der vorangehenden Ansprüche, **dadurch gekennzeichnet, dass** zwischen dem Vergleicher (19) und der Auswerteeinrichtung (22) ein dritter Tiefpassfilter (21) liegt.

8. Feldgerät nach einem der Ansprüche 1 bis 6, **dadurch gekennzeichnet, dass** der Auswerteeinrichtung (22) eine Zähleinrichtung (30) zugeordnet ist, wobei die Auswerteeinrichtung (22) die Fehlermeldung (23) erzeugt, wenn die Häufigkeit der das vorgegebene Maß überschreitenden Abweichungen zwischen beiden verglichenen Signalen (17, 18) eine vorgegebene Anzahl überschreitet.

9. Feldgerät nach einem der vorangehenden Ansprüche bestehend aus einem Messumformer bei dem
- ein Sensor (1) eine physikalische Größe erfasst und in ein elektrisches Rohsignals (2) umsetzt,
- die Signalverarbeitungseinrichtung (3) das Rohsignal (2) in das digitales Messsignal (4) umsetzt und
- die Ausgangsstufe (5) ein dem digitalen Messsignal (4) entsprechendes niederfrequentes analoges Stromsignal (I) abgibt.

10. Feldgerät nach einem der Ansprüche 1 bis 8 bestehend aus einer Regel- oder Stelleinrichtung bei der
- die Signalverarbeitungseinrichtung (3) das digitales Steuer- oder Regelsignal (4) erzeugt, und
- die Ausgangsstufe (5) mit dem niederfrequenten analogen Spannungs- oder Stromsignal (U, I) ein Stellglied (24 bis 26) steuert.

## Claims

1. Field device for process automation, having
- a signal processing device (3) which generates a digital measurement, control or regulation signal (4),
- an output stage (5) which converts the digital measurement, control or regulation signal (4) into a corresponding low-frequency analogue voltage or current signal (U, I), and
- a monitoring device (10) comprising
- a measuring device (11) which detects the analogue voltage or current signal (U, I) and converts it into a digital voltage or current measurement signal (13), and
- a comparator (19) which is downstream of the signal processing device (3) and the measuring device (11),
**characterized**
- **in that** a first digital low-pass filter (15) for filtering the digital measurement, control or regulation signal (4) is situated between the signal processing device (3) and the comparator (19), the cut-off frequency of the low-pass filter (15) being lower than the cut-off frequency of the output stage (5),
- **in that** a second digital low-pass filter (16) having the same cut-off frequency as that of the first digital low-pass filter (15) for filtering the digital voltage or current measurement signal (13) is situated between the measuring device (11) and the comparator (19), and
- **in that** an evaluation device (22) is downstream of the comparator (19) and generates an error message (23) if the difference between the two compared signals (17, 18) exceeds a predefined amount.

2. Field device as claimed in Claim 1, **characterized in that** the output stage (5) comprises a pulse width modulator (7) followed by an analogue low-pass filter (8) in order to generate the analogue voltage signal (U).

3. Field device as claimed in Claim 1, **characterized in that** the output stage (5) comprises a pulse width modulator (7) followed by an analogue low-pass filter (8) and a voltage/current converter (9) downstream of the latter in order to generate the analogue current signal (I).

4. Field device as claimed in one of the preceding claims, **characterized in that** the cut-off frequency of the two digital low-pass filters (15, 16) is a multiple lower than the cut-off frequency of the output stage (5).

5. Field device as claimed in Claim 3, **characterized in that** the cut-off frequency of the output stage (5) is a multiple higher than the cut-off frequency of the low-frequency voltage or current signal (U, I).

6. Field device as claimed in one of the preceding claims, **characterized in that** a delay stage (14) which delays the digital measurement, control or regulation signal (4) supplied to the first digital low-pass filter (15) is upstream of the latter, the delay of which delay stage corresponds to the signal delay from the output of the signal processing device (3) to the output of the measuring device (11).

7. Field device as claimed in one of the preceding claims, **characterized in that** a third low-pass filter (21) is between the comparator (19) and the evaluation device (22).

8. Field device as claimed in one of Claims 1 to 6, **characterized in that** a counter (30) is assigned to the evaluation device (22), the evaluation device (22) generating the error message (23) if the frequency of the differences between the two compared signals (17, 18), which exceed the predefined amount, exceeds a predefined number.

9. Field defined as claimed in one of the preceding claims, consisting of a measuring transducer in which
- a sensor (1) detects a physical variable and converts it into an electrical raw signal (2),
- the signal processing device (3) converts the raw signal (2) into the digital measurement signal (4), and
- the output stage (5) emits a low-frequency analogue current signal (I) corresponding to the digital measurement signal (4).

10. Field device as claimed in one of Claims 1 to 8 consisting of a regulating or actuating device in which
- the signal processing device (3) generates the digital control or regulation signal (4), and
- the output stage (5) controls an actuator (24 to 26) using the low-frequency analogue voltage or current signal (U, I).

## Revendications

1. Appareil sur site pour l'automatisation de processus comprenant
- un dispositif ( 3 ) de traitement du signal qui produit un signal ( 4 ) numérique de mesure, de commande ou de régulation,
- un étage ( 5 ) de sortie qui transforme le signal ( 4 ) numérique de mesure de commande ou de régulation en un signal ( U, I ) analogique de tension ou de courant en basse fréquence correspondant, et
- un dispositif ( 10 ) de contrôle comprenant
- un dispositif ( 11 ) de mesure qui détecte le signal ( U, I ) analogique de tension ou de courant et le transforme en un signal ( 13 ) numérique de tension ou de courant, et
- un comparateur ( 19 ) monté en aval du dispositif ( 3 ) de traitement du signal et du dispositif ( 11 ) de mesure,
**caractérisé**
- **en ce qu'**un premier filtre ( 15 ) passe-bas est, pour le filtrage du signal ( 4 ) numérique de mesure, de commande ou de régulation, monté entre le dispositif ( 3 ) de traitement du signal et le comparateur ( 19 ), la fréquence de coupure du filtre ( 15 ) passe-bas étant plus petite que la fréquence limite de l'étage ( 5 ) de sortie,
- **en ce qu'**entre le dispositif ( 11 ) de mesure et le comparateur ( 19 ) est monté, pour le filtrage du signal ( 13 ) numérique de tension ou de courant, un deuxième filtre ( 16 ) passe-bas numérique ayant la même fréquence de coupure que le premier filtre ( 15 ) passe-bas numérique, et
- **en ce qu'**en aval du comparateur ( 19 ) est monté un dispositif ( 22 ) d'exploitation qui produit un message ( 23 ) d'erreur si l'écart entre deux signaux ( 17, 18 ) comparés dépasse une valeur donnée à l'avance.

2. Appareil sur site suivant la revendication 1, **caractérisé en ce que** l'étage ( 5 ) de sortie comprend, pour la production du signal ( U ) analogique de tension, un modulateur ( 7 ) de largeur d'impulsion suivi d'un filtre ( 8 ) passe-bas analoguique.

3. Appareil sur site suivant la revendication 1, **caractérisé en ce que** l'étage ( 5 ) de sortie comprend, pour la production du signal ( 1 ) de courant analogique, un modulateur ( 7 ) de largeur d'impulsion suivi d'un filtre ( 8 ) passe-bas analogique et d'un convertisseur ( 9 ) tension/courant en aval de celui-ci.

4. Appareil sur site suivant l'une des revendications précédentes, **caractérisé en ce que** la fréquence de coupure des deux filtres ( 15, 16 ) passe-bas numériques est plus petite d'un multiple que la fréquence limite de l'étage ( 5 ) de sortie.

5. Appareil sur site suivant la revendication 3, **caractérisé en ce que** la fréquence limite de l'étage ( 5 ) de sortie est plus grande d'un multiple que la fréquence limite du signal ( U, ) de tension ou de courant en basse fréquence.

6. Appareil sur site suivant l'une des revendications précédentes, **caractérisé en ce qu'**en amont du premier filtre ( 15 ) passe-bas numérique est monté un étage ( 14 ) temporisateur retardant le signal ( 4 ) de mesure de commande ou de régulation numérique qui lui est envoyé et dont le retard correspond au retard du signal de la sortie du dispositif ( 3 ) de traitement du signal à la sortie du dispositif ( 11 ) de mesure.

7. Appareil sur site suivant l'une des revendications précédentes, **caractérisé en ce qu'**un troisième filtre ( 21 ) passe-bas est monté entre le comparateur ( 19 ) et le dispositif ( 22 ) d'exploitation.

8. Appareil sur site suivant l'une des revendications 1 à 6, **caractérisé en ce qu'**au dispositif ( 22 ) d'exploitation est associé un dispositif ( 30 ) de comptage, le dispositif ( 22 ) d'exploitation produisant le message ( 23 ) d'erreur si la fréquence des écarts dépassant la valeur donnée à l'avance entre les deux signaux ( 17, 18 ) comparés dépasse un nombre donnée à l'avance.

9. Appareil sur site suivant l'une des revendications précédentes, constitué d'un convertisseur de mesure dans lequel
- un capteur ( 1 ) détecte une grandeur physique et la transforme en un signal ( 2 ) brut électrique,
- le dispositif ( 3 ) de traitement du signal transforme le signal ( 2 ) brut en le signal ( 4 ) de mesure numérique, et
- l'étage ( 5 ) de sortie émet un signal ( I ) de courant analogique en basse fréquence correspondant au signal ( 4 ) de mesure numérique.

10. Appareil sur site suivant l'une des revendications 1 à 8, constitué d'un dispositif de régulation ou de réglage dans lequel
- le dispositif ( 3 ) de traitement du signal produit le signal ( 4 ) de commande ou de régulation numérique, et
- l'étage ( 5 ) de sortie commande un actionneur ( 24 à 26 ) par le signal ( U, I ) de tension ou de courant analogique en basse fréquence.
